# EUROPEAN PATENT APPLICATION

(11) **EP 4 030 175 A1**
(43) Date of publication of application: **20.07.2022**
(21) Application number: 21152382.4
(22) Date of filing: 19.01.2021
(51) Int. Cl.: G01R 31/08, H01B 7/32, G01B 21/00, G01B 7/12

(54) **DETECTION SYSTEM, ELECTRIC CABLE, AND METHOD**

(71) Applicant: Vestel Elektronik Sanayi ve Ticaret A.S., 45030 Manisa (TR)
(72) Inventor: ERDINC, Cihan, 45030 Manisa (TR)
(74) Representative: Kehl, Ascherl, Liebhoff & Ettmayr Patentanwälte Partnerschaft mbB

(57) **Abstract**

The present disclosure provides a detection system (100) for detecting deformations in an electric cable (250, 350), the detection system (100) comprising a number of sensor groups (101, 102, 103, 201) arranged consecutively on the electrical cable in a direction of longitudinal extension of the electrical cable, each one of the sensor groups (101, 102, 103, 201) comprising a number of shape sensors (104, 105, 204, 205, 304, 305, 310, 311), wherein the shape sensors (104, 105, 204, 205, 304, 305, 310, 311) are configured to detect a change of a shape of a cross section area of the electric cable (250, 350) at the position of the respective sensor group (101, 102, 103, 201) and to output a respective signal (106, 107). Further, the present invention provides a respective electric cable (250, 350) and a respective method.

## Description

### TECHNICAL FIELD

The present disclosure relates to a detection system, an electric cable and a respective method.

### BACKGROUND

Although applicable to any cable, the present disclosure will mainly be described in conjunction with electric cables for charging electric vehicles.

Modern vehicles may be equipped with an electric motor that assists a combustion engine or that replaces the combustion engine to reduce the exhaust fumes generated by the vehicle. Such vehicles may be called electric vehicles if the combustion engine is replaced by an electric engine, or plug-in hybrid vehicles if the combustion engine is assisted by the electric engine. In the following the term electric vehicle will be used to refer to any type of vehicle with an electric engine that may be charged via an external power source.

Charging stations for electric vehicles require high current carrying charging cables to provide the electrical energy required to charge the batteries of electric vehicles. Such cables may be permanently attached to the charging station or the users may bring their own charging cables to the charging station. Charging cables have to be long enough to couple a vehicle to a charging station in different situations. Therefore, in occasions parts of the charging cable may touch the ground. Especially but not only when touching the ground, the charging cable may be damaged or squeezed easily. Such a damaged charging cable may comprise a damaged insulation cover. This should be avoided.

Accordingly, there is a need for detecting damaged charging cables.

### SUMMARY

The above stated problem is solved by the features of the independent claims. It is understood, that independent claims of a claim category may be formed in analogy to the dependent claims of another claim category.

Accordingly, it is provided:
A detection system for detecting deformations in an electric cable, the detection system comprising a number i.e., one or more, of sensor groups arranged consecutively on the electrical cable in a direction of longitudinal extension of the electrical cable, each one of the sensor groups comprising a number i.e., one or more, of shape sensors, wherein the shape sensors are configured to detect a change of a shape of a cross section area of the electric cable at the position of the respective sensor group and to output a respective signal.

Further, it is provided:
An electric cable comprising a number i.e., one or more, of electrical wires, a tubular insulation cover, wherein the electrical wires are arranged in an inner open space surrounded by the tubular insulation cover, and a detection system according to the present disclosure, wherein the shape sensors are arranged in the material of the insulation cover.

Further, it is provided:
A method for detecting deformations in an electric cable, the method comprising sensing with a number i.e., one or more, of shape sensors arranged in a number i.e., one or more, of sensor groups that are provided consecutively on the electrical cable in a direction of longitudinal extension of the electrical cable a change of a shape of a cross section area of the electric cable at the position of the respective sensor group, and outputting with each one of the sensors a respective signal.

The present disclosure is based on the finding that electric cables usually comprise a fixed cross section shape, especially a round or oval cross section shape, when they are undamaged. Further, the disclosure acknowledges that damages to electric cables usually result in a deformation of the cross section of the electric cable.

For example, an electric cable for charging an electric vehicle may get squeezed by a tire of the electric vehicle, if the electric cable is lying on the floor and the vehicle moves over the electric cable.

Deformations, like squeezing, of an electric cable may result in the insulation of the cable being damaged and/or in internal wires of the cable being damaged. The damaging of the insulation may result in high voltages being present on the outside of the electric cable, and internal wire damages may result in short-circuits.

The present invention therefore provides the detection system for detecting deformations of electric cables, especially of the cross section area of the electric cable, which may be caused by squeezing, bending or folding of the cable.

The detection system comprises a number of sensor groups. The sensor groups are arranged consecutively on the electrical cable in a direction of longitudinal extension of the electrical cable. It is understood, that any number of sensor groups starting from one sensor group is possible. It is also understood, that if multiple sensor groups are provided, the sensor groups may be provided in a predetermined distance from each other along the cable.

Each one of the sensor groups comprises a number of shape sensors. The shape sensors are sensors that may at least detect a change of a shape of a cross section area of the electric cable at the position of the respective sensor group or shape sensor. It is understood, that any type of sensor may be used as shape sensor that provides a change in an output signal if the shape of the cross section of the electric cable changes.

A change of the shape of the cross section of the electric cable is usually caused by squeezing or bending of the electrical cable and may therefore provide an adequate indication of the condition of the electric cable.

A respective signal provided by one or more of the shape sensors may consequently be used as indication of a damage of the electric cable. It is understood, that the signals provided by the shape sensors may be received e.g. by a controller in a charging station for electrical vehicles or a controller in the electrical vehicle. Such a controller may in response to respective signals from the shape sensors provide a warning signal to the user of the charging station or the electric vehicle.

The electric cable of the present disclosure may comprise a plurality of wires for transmitting high power electrical current and/or electrical wires for transmitting data. Especially in the case of an electric cable for charging an electric vehicle the electric cable may comprise phase wires, ground wires and PE wires (protective earth). In addition, data cables may be provided.

The electric cable comprises a tubular insulation cover. Such an insulation cover may e.g. be made of rubber or any other flexible material. The electrical wires of the electric cable are provided inside the tubular insulation cover. It is understood, that other elements, like individual shielding and cover or coating may be provided for the single wires, or the inner open space may be filled with a filling material around the wires.

In such an electric cable, the detection system may be integrated into the insulation cover. In such an embodiment, the single shape sensors of the sensor groups of the detection system may be provided in the insulation cover i.e., in the outer shell of the electric cable. It is understood, that the cabling required to supply electrical power to the shape sensors and to read signals from the shape sensors may also be provided in the insulation cover.

Further embodiments of the present disclosure are subject of the further dependent claims and of the following description, referring to the drawings.

In an embodiment, each sensor group may comprise two shape sensors. Each one of the two shape sensors is positioned on a respective axis, and the two axes are parallel to the cross section area of the electric cable and intersect in the cross section area of the electric cable, especially in the center of the cross section area. In addition, the axes may be arranged orthogonal to each other.

If two shape sensors are used that are provided on different axes that intersect on the cross section area of the electric cable, the shape sensors are provided on different positions of the circumference of the electric cable. Especially, if the angle between the axes is 90° or about 90° +/- 5°, +/- 4°, +/- 3°, +/- 2°, +/- 1°, i.e., when the axes are orthogonal or nearly orthogonal to each other, the shape may simply be determined by measuring e.g., the distance of the respective shape sensor to the current conducting wires in the electric cable. As alternative, the length of the cross section area of the electric cable on the respective axis may be measured by the respective sensor.

Usually, the electric cable will comprise a round cross section area. Therefore, the measurements provided by the two shape sensors should provide approximately the same value. If a cable is squeezed, however, the sensor that is provided on the or nearer to the squeezing axis will be pushed to the center of the cross section area of the electric cable and provide a smaller value for the distance or size. The other sensor will be pushed away from the center of the cross section area and provide a larger value for the distance or size.

If the signals provided by the two shape sensors indicate strongly diverging values, it may, therefore, be inferred that the shape of the cross section area of the electric cable is not round. A non-round shape of the cross section area of the electric cable may indicate that the electric cable is squeezed or bent and may be damaged. Such diverging values may therefore be used as a basis to provide the warning signal to a user.

A threshold value may be given for the difference between the signals provided by the two shape sensors. Such a threshold value may be predetermined during development or production of the detection system or the electric cable and may be stored for each shape sensor in a detection system or electric cable. The threshold value may be provided as absolute value or as relative value. If a relative value is used, the threshold value may refer to the measured value or to another value derived from the measured value. If for example, a magnetic field strength is measured by the shape sensors, the threshold value may refer to the magnetic field strength or the voltage of the signal that represents a respective magnetic field strength. Possible values for the relative threshold value may be 50%, 40%, 30%, 20%, 10%. The threshold value may especially be based on the rigidity and/or mechanical stability of the electric cable, which may be determined in respective experiments. If for example, it is known that an electric cable is damaged if it is squeezed by more then 20%, the threshold value may be set blow this value, e.g. 15%.

It is understood that an electric cable may also comprise a non-round shape, e.g. an oval shape. For such cable, different threshold values may be defined that consider the shape of the electric cable. If for example, one of the shape sensors with a non-squeezed cable provides a signal that is 30% larger than the signal of the other sensors, the threshold value may be defined as a deviation of said 30%.

It is understood, that due to the measurement principle of the shape sensors, the shape sensors may provide diverging signals, even if the electric cable is round and not squeezed. In such an embodiment, the same principles as described above may be applied to the diverging sensor signals.

In a further embodiment, each sensor group may comprise four shape sensors. In each case two of the shape sensors are positioned on a respective axis on opposing sides of the electric cable, and the two axes are parallel to the cross section area of the electric cable and intersect in the cross section area of the electric cable, especially in the center of the cross section area. In addition, the axes may be arranged orthogonal to each other.

With four shape sensors that are arranged as opposing pairs the measurement may be improved. For example, for each axis a value may be calculated as the average of the signal values provided by the two sensors on the respective axis. For the average values the above-description regarding the embodiment with two sensors applies mutatis mutandis.

Further, other types of sensors may be used that for example implement a sender-receiver principle. One sensor on an axis may provide a signal that is received by the other sensor on the same axis and that is influenced by the distance between the two sensors.

Especially, if a sender receiver principle is used, the sensors may be activated independently of the cable being used or not. The cable may therefore be tested periodically and independently of a charging station, i.e. during regular servicing intervals.

In another embodiment, only a single shape sensor may be provided in every sensor group. In such an embodiment, absolute values for every shape sensor may be known for an undamaged state of the electric cable. The signals provided by the shape sensors may then be compared to the respective absolute values and a damaged electric cable may be identified if the deviation is too large.

In another embodiment, at least one of the shape sensors may comprise a hall-effect sensor configured to sense a magnetic field that is created by the wires in the electric cable when the wires conduct electric current.

Hall-effect sensors are common sensors for sensing magnetic fields. A magnetic field is generated around a wire that conducts electric current. When the electric cable is used for charging an electric vehicle, current is provided via the electric cable from a charging station to the electric vehicle. Therefore, a magnetic field is generated around the current carrying wires in the electric cable.

Using hall effect sensors allows easily implementing the shape sensors by measuring the strength of the magnetic field around the wires as an indication of the shape of the cross section area of the electric cable.

In an embodiment with four shape sensors in each sensor group, one of the shape sensors on each axis may be a hall-effect sensor. The other sensor may be a magnetic field generator. The magnetic field generated by the magnetic field generator may be sensed by the hall-effect sensor, and changes in the distance between the two sensors will be visible in the signal provided by the hall-effect sensor. In an embodiment with four shape sensors in each sensor group, it is also possible to provide one magnetic field generator in each sensor group and three or four hall-effect sensors.

In an embodiment, the detection system may comprise a detection processor that is coupled to the shape sensors and that is configured to monitor the signals provided by the shape sensors for a change of the shape of the cross section area of the electric cable at the position of the respective sensor group.

The detection processor may e.g. be coupled to each one of the shape sensors and if available the magnetic field generators via discrete signal lines. As alternative, the shape sensors, and if available the magnetic field generators, may be coupled to the detection processor via a data bus e.g., a serial data bus, like a SPI Bus, a I²C Bus, a RS485 bus or the like.

As alternative, the single shape sensors may comprise a wireless interface and communicate measurement values via a wireless communication system. To this end, the single shape sensors may comprise an energy harvesting device that may harvest electrical energy from the magnetic field generated in the wires of the electric cable when a vehicle is charged.

In an embodiment, a communication controller may be provided for every sensor group or multiple sensor groups. The communication controller may control the shape sensors, and if available the magnetic field generator, and may be coupled to the energy harvesting device. Using a communication controller allows grouping shape sensors, which then do not require a dedicated communication unit.

The detection processor may be implemented in the detection system as a dedicated processor. As alternative, the detection processor may be provided external to the detection system and may e.g. be integrated in a charging station or an electric vehicle.

In yet another embodiment, the detection processor may be configured to store for each one of the shape sensors a target value and to determine if the signal provided by at least one of the shape sensors deviates from the respective target value by more than a predetermined threshold value. The detection processor may further be configured to output a positive deformation signal if the signal provided by at least one of the shape sensors deviates from the respective target value by more than a predetermined threshold value.

The detection processor may monitor every single shape sensor, in the case of hall-effect sensors e.g. the magnetic field strength measured by the single hall-effect sensors. It is understood, that the target values may be variable and may depend on the current that is flowing through the wires of the electric cable. This information may be provided to the detection processor from a charging station of an electric vehicle.

If the distance between the wires and the shape sensors is known and the current that is flowing through the wires in the electric cable is also known, the magnetic field strength that should be measured by every shape sensor may be calculated.

If other types of sensors are used or for example, a magnetic field generator is provided in the sensor groups, the respectively known values may be stored in the detection processor for the single shape sensors.

In a further embodiment, the detection processor may be configured to output the positive deformation signal if during operation of the detection system the signal provided by at least one of the shape sensors changes more than a predetermined maximum change value.

A change of the signal provided by a shape sensor by more than a predetermined maximum change value during operation of the detection system may indicate that the electric cable is currently squeezed. Therefore, in such a case, the detection processor may output a respective positive deformation signal.

In yet another embodiment, the detection processor may be configured to output the positive deformation signal if the signals provided by at least two shape sensors of the same sensor group that are positioned on different axes deviate from each other by more than a maximum deviation value.

As explained above, if shape sensors are provided on two axes, the sensors on one axis will show an increasing value i.e., increasing distance or size, while the sensors on the other axis will show a decreasing value i.e., decreasing distance or size when a cable is squeezed.

Using the values of sensors on two axis in each sensor group provides for a more robust assessment of the deformation of the shape of the cross section area of the electric cable.

In another embodiment, the detection processor may be configured to output the positive deformation signal only if the condition for outputting the positive deformation signal exists for more than a predetermined amount of time.

The electric cable may only be squeezed shortly and then revert back to its original size and/or shape. If the electric cable after being squeezed reverts back to its original size and/or shape it may be assumed that the electric cable is not permanently damaged.

Therefore, a timeout in the form of the predetermined amount of time may be applied by the detection processor prior to outputting the positive deformation signal.

In a further embodiment, the detection system may comprise a flexible sheet, wherein the shape sensors may be embedded in the flexible sheet, and the flexible sheet may be configured to wrap around the electric cable.

Providing a flexible sheet e.g., a rubber sheet or a foam sheet, and including the shape sensors in this sheet, allows wrapping the sheet around an already existing cable. Therefore, the detection system may be retrofitted onto existing cables.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a detection system according to the present disclosure;
Figure 2 shows a schematic diagram of an embodiment of an electric cable according to the present disclosure;
Figure 3 shows a cross-sectional view of an embodiment of an electric cable according to the present disclosure;
Figure 4 shows a further cross-sectional view of the embodiment of an electric cable of

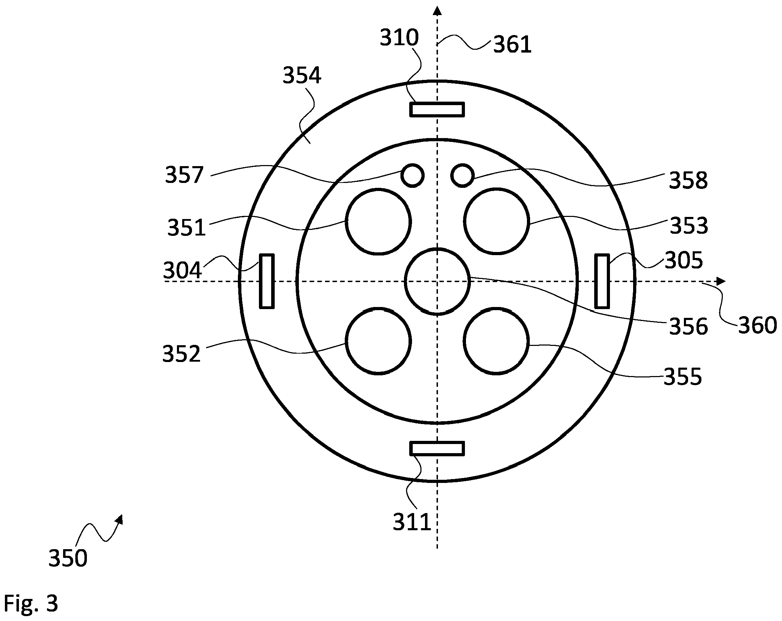

Figure 3; and

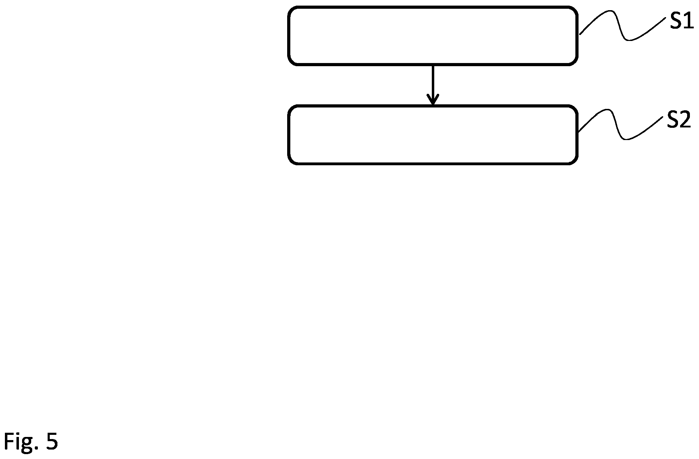

Figure 5 shows a flow diagram of an embodiment of a method according to the present disclosure.

In the figures like reference signs denote like elements unless stated otherwise.

### DETAILED DESCRIPTION OF THE DRAWINGS

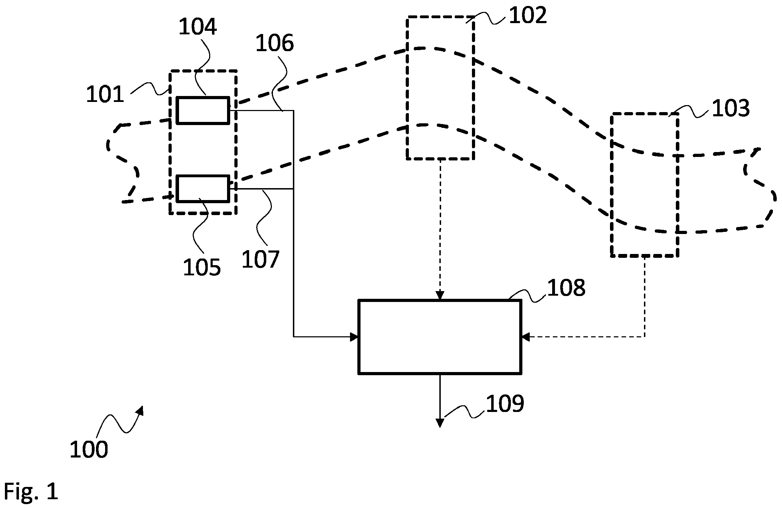

Figure 1 shows a block diagram of a detection system 100. The detection system 100 serves for detecting deformations in an electric cable, hinted at by dashed lines.

The detection system 100 comprises three sensor groups 101, 102, 103. It is understood, that the number of three sensor groups 101, 102, 103 is just exemplarily chosen and that any number of sensor groups may be provided in a detection system 100 starting with one sensor group.

The sensor groups 101, 102, 103 may be arranged consecutively on the electrical cable in a direction of longitudinal extension of the electrical cable.

The sensor group 101 is shown with two shape sensors 104, 105. It is understood, that any number of shape sensors may be provided in each sensor group. The sensor groups 102, 103 may be provided analogously to sensor group 101 with respective shape sensors, which are not shown for sake of clarity.

The shape sensors 104, 105 are configured to detect a change of a shape of a cross section area of the electric cable at the position of the respective sensor group and to output a respective signal 106, 107.

In the detection system 100 a detection processor 108 is coupled to the shape sensors 104, 105 of the sensor groups 101, 102, 103. It is understood, that the detection processor 108 not necessarily needs to be provided as part of the detection system 100. Instead, the detection processor 108 may also be provided separately or as part of the electric cable, a charging station or an electric vehicle.

The detection processor 108 monitors the signals 106, 107 provided by the shape sensors 104, 105 for a change of the shape of the cross section area of the electric cable and provides a respective deformation signal 109. The detection processor 108 will provide a positive deformation signal 109 if the signals 106, 107 indicate that the shape of the electric cable changed.

The detection processor 108 may provide a positive deformation signal 109 under different circumstances.

For example, the detection processor 108 may store for each one of the shape sensors 104, 105 a target value and determine if the signal 106, 107 provided by at least one of the shape sensors 104, 105 deviates from the respective target value by more than a predetermined threshold value. The detection processor 108 may in this embodiment output a positive deformation signal 109 if the signal 106, 107 provided by at least one of the shape sensors 104, 105 deviates from the respective target value by more than the predetermined threshold value.

Further, in addition or as alternative, the detection processor 108 may output the positive deformation signal 109 if during operation of the detection system 100 the signal 106, 107 provided by at least one of the shape sensors 104, 105 changes more than a predetermined maximum change value. Further, in addition or as alternative, the detection processor 108 may output the positive deformation signal 109 if the signals 106, 107 provided by at least two shape sensors 104, 105 of the same sensor group 101, 102, 103 that are positioned on different axes deviate from each other by more than a maximum deviation value. Further, in embodiments, the detection processor 108 may output the positive deformation signal 109 only if the condition for outputting the positive deformation signal 109 exists for more than a predetermined amount of time.

The detection system 100 is shown without an electric cable, which is only hinted at by dashed lines. The detection system 100 may comprising a flexible sheet (not shown), and the shape sensors 104, 105 may be embedded in the flexible sheet. Embedding the shape sensors 104, 105 in a flexible sheet allows wrapping the flexible sheet with the shape sensors 104, 105 around the electric cable, and therefore retrofitting an electric cable with the detection system 100.

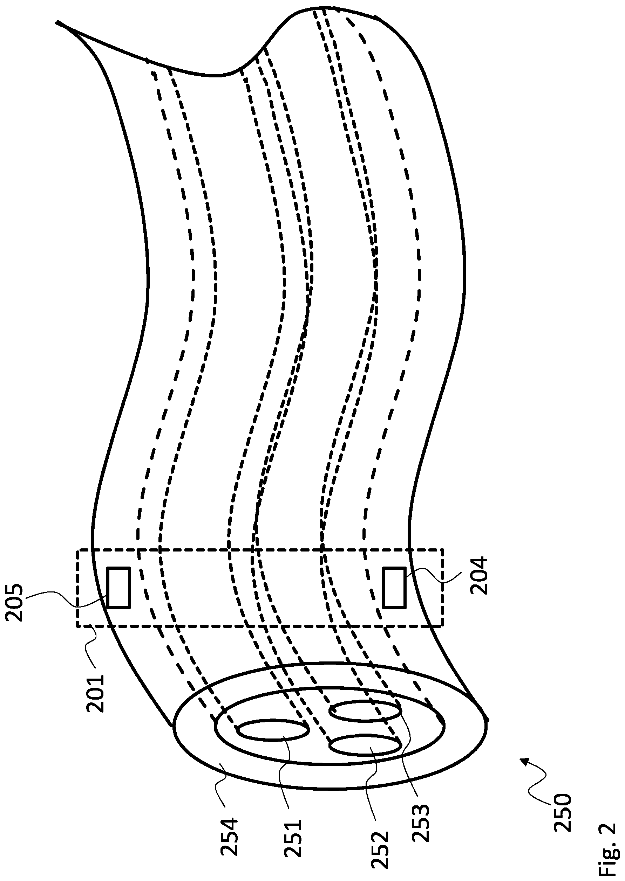

Figure 2 shows a schematic diagram of an electric cable 250. The electric cable 250 comprises three wires 251, 252, 253, that are arranged inside of a tubular insulation cover 254. It is understood, that the number of three wires 251, 252, 253 is just exemplarily chosen and that a cable according to the present disclosure may comprise any number of wires starting with one wire.

The electric cable 250 further comprises a detection system according to the present disclosure. To this end, shape sensors 204, 205 are provided in the material of the tubular insulation cover 254. It is understood, that in other embodiments, the shape sensors 204, 205 may be provided external to the tubular insulation cover 254 and may be fixed to the tubular insulation cover 254 on the outside.

The communication with the shape sensors 204, 205 may be performed in different ways. As explained above, discrete signal lines may be provided to each one of the shape sensors 204, 205. As alternative a data bus may be provided or wireless communication may be used.

The electric cable 250, although not shown, may comprise connectors on each end, especially connectors for coupling the electric cable 250 to a charging station and to an electric vehicle. It is understood, that if an external detection processor is used i.e., a detection processor that is not provided within the cable or the connectors, these connectors may provide means for data communication between the external detection processor and the shape sensors 204, 205.

Figure 3 shows a cross-sectional view of an electric cable 350 in a non-squeezed state. The electric cable 350 comprises five high power wires 351, 352, 353, 355, 356 and two data wires 357, 358. The high power wires 351, 352, 353, 355, 356 and the data wires 357, 358 are surrounded by a tubular insulation cover 354. Again, it is understood, that an electric cable according to the present disclosure may comprise any number of wires starting with one wire. The high power wires 351, 352, 353, 355, 356 may e.g. comprise three phase wires, a ground wire and a PE wire (protective earth).

Arranged in the tubular insulation cover 354 four shape sensors 304, 305, 310, 311 are provided. Shape sensors 304, 305 are provided on a first axis 360, which is horizontally oriented. Shape sensor 304 is provided on the left side of the electric cable 350, while shape sensor 305 is provided on the right side of the electric cable 350. Shape sensors 310, 311 are provided on a second axis 361, which is vertically oriented. Shape sensor 310 is provided on the upper side of the electric cable 350, and shape sensor 311 is provided on the lower side of the electric cable 350. The two axis intersect in the center of the cross-sectional area of the electric cable 350.

If electric current runs through the high power wires 351, 352, 353, 355, 356, a magnetic field is generated around the high power wires 351, 352, 353, 355, 356, which may be sensed by hall-effect type shape sensors 304, 305, 310, 311.

As can be seen in figure 3, if the electric cable 350 is not squeezed, the distance of the shape sensors 304, 305, 310, 311 to the wire package is about the same for all sensors. It is understood, that individual differences in the distance of the shape sensors 304, 305, 310, 311 to the single high power wires 351, 352, 353, 355, 356 may be accounted for by a respective calibration, as indicated above.

In the shown state, the output signals provided by the shape sensors 304, 305, 310, 311 are similar at least within a respective tolerance.

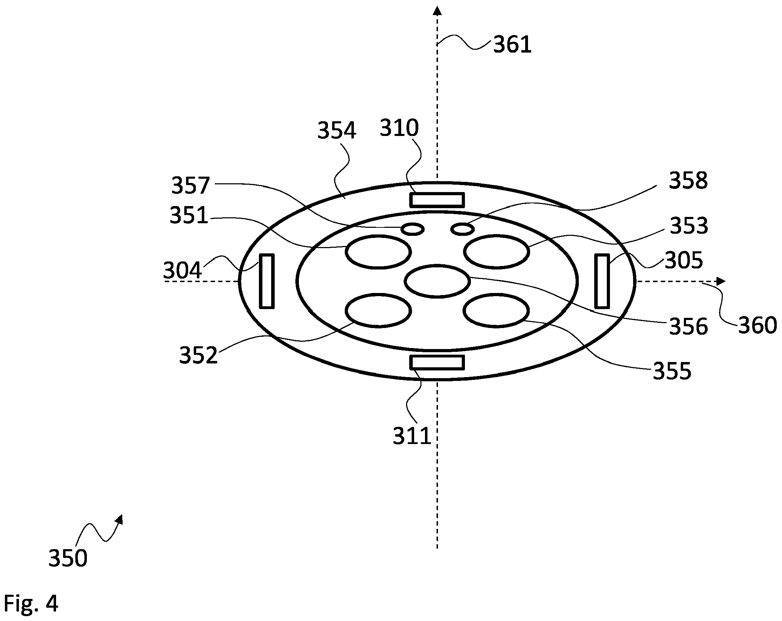

Figure 4 shows a further cross-sectional view of the electric cable 350 with the cable 350 being squeezed in vertical direction.

It can be seen that the electric cable 350 being squeezed leads to a reduction of the distance between the shape sensors 310, 311 and the high power wires 351, 352, 353, 355, 356. In contrast, the distance between the shape sensors 304, 305 and the high power wires 351, 352, 353, 355, 356 is increased.

Generally, the output signal of the pair of shape sensors 304, 305, 310, 311 that is brought closer to the high power wires 351, 352, 353, 355, 356 will increase, while the output signal of the pair of shape sensors 304, 305, 310, 311 that is further spaced away from the high power wires 351, 352, 353, 355, 356 is decreased.

This change in the output signals may be detected by a respective detection processor and may be evaluated to provide the respective deformation signal.

For sake of clarity in the following description of the method-based Fig. 5 the reference signs used above in the description of apparatus-based Figs. 1 - 4 will be maintained.

Figure 5 shows a flow diagram of a method for detecting deformations in an electric cable 250, 350.

The method comprises sensing S1 with a number of shape sensors 104, 105, 204, 205, 304, 305, 310, 311 arranged in a number of sensor groups 101, 102, 103, 201 that are provided consecutively on the electrical cable in a direction of longitudinal extension of the electrical cable a change of a shape of a cross section area of the electric cable 250, 350 at the position of the respective sensor group 101, 102, 103, 201. Further, the method comprises outputting S2 with each one of the sensors a respective signal 106, 107.

The step of sensing may be performed with two shape sensors 104, 105, 204, 205, 304, 305, 310, 311 in each sensor group 101, 102, 103, 201. Each one of the two shape sensors 104, 105, 204, 205, 304, 305, 310, 311 may be positioned on a respective axis 360, 361, and the two axes may be parallel to the cross section area of the electric cable 250, 350 and intersect in the cross section area of the electric cable 250, 350, especially in the center of the cross section area. The axes may be arranged orthogonal to each other.

As alternative, the step of sensing may be performed with four shape sensors 104, 105, 204, 205, 304, 305, 310, 311 in each sensor group 101, 102, 103, 201. In each case two of the shape sensors 104, 105, 204, 205, 304, 305, 310, 311 may be positioned on a respective axis 360, 361 on opposing sides of the electric cable 250, 350, and the two axes may be parallel to the cross section area of the electric cable 250, 350 and intersect in the cross section area of the electric cable 250, 350, especially in the center of the cross section area. The axes may be arranged orthogonal to each other.

At least one shape sensor 104, 105, 204, 205, 304, 305, 310, 311 may comprise a hall-effect sensor configured to sense a magnetic field that is created by the wires 251, 252, 253, 351, 352, 353, 355, 356, 357, 358 in the electric cable 250, 350 when the wires 251, 252, 253, 351, 352, 353, 355, 356, 357, 358 conduct electric current.

A positive deformation signal 109 may be provided if the signal 106, 107 provided by at least one of the shape sensors 104, 105, 204, 205, 304, 305, 310, 311 deviates from a respective target value by more than a predetermined threshold value. In addition, or as alternative, a positive deformation signal 109 may be provided if the signal 106, 107 provided by at least one of the shape sensors 104, 105, 204, 205, 304, 305, 310, 311 changes more than a predetermined maximum change value while the method is performed. Further in addition or as alternative, a positive deformation signal 109 may be output if the signals 106, 107 provided by at least two shape sensors 104, 105, 204, 205, 304, 305, 310, 311 of the same sensor group 101, 102, 103, 201 that are positioned on different axes deviate from each other by more than a maximum deviation value.

The positive deformation signal 109 may in an embodiment be output only if the condition for outputting the positive deformation signal 109 exists for more than a predetermined amount of time.

Although specific embodiments have been illustrated and described herein, it will be appreciated by those of ordinary skill in the art that a variety of alternate and/or equivalent implementations exist. It should be appreciated that the exemplary embodiment or exemplary embodiments are only examples, and are not intended to limit the scope, applicability, or configuration in any way. Rather, the foregoing summary and detailed description will provide those skilled in the art with a convenient road map for implementing at least one exemplary embodiment, it being understood that various changes may be made in the function and arrangement of elements described in an exemplary embodiment without departing from the scope as set forth in the appended claims and their legal equivalents. Generally, this application is intended to cover any adaptations or variations of the specific embodiments discussed herein.

### LIST OF REFERENCE SIGNS

- 100: detection system
- 101, 102, 103, 201: sensor group
- 104, 105, 204, 205: shape sensor
- 304, 305, 310, 311: shape sensor
- 106, 107: signal
- 108: detection processor
- 109: deformation signal
- 250, 350: electric cable
- 251, 252, 253: wire
- 351, 352, 353, 355, 356, 357, 358: wire
- 254, 354: tubular insulation cover
- 360, 361: axis
- S1, S2: method steps

## Claims

1. Detection system (100) for detecting deformations in an electric cable (250, 350), the detection system (100) comprising:
a number of sensor groups (101, 102, 103, 201) arranged consecutively on the electrical cable in a direction of longitudinal extension of the electrical cable, each one of the sensor groups (101, 102, 103, 201) comprising a number of shape sensors (104, 105, 204, 205, 304, 305, 310, 311) wherein the shape sensors (104, 105, 204, 205, 304, 305, 310, 311) are configured to detect a change of a shape of a cross section area of the electric cable (250, 350) at the position of the respective sensor group (101, 102, 103, 201) and to output a respective signal (106, 107).

2. Detection system (100) according to claim 1, wherein each sensor group (101, 102, 103, 201) comprises two shape sensors (104, 105, 204, 205, 304, 305, 310, 311), wherein each one of the two shape sensors (104, 105, 204, 205, 304, 305, 310, 311) is positioned on a respective axis (360, 361), and wherein the two axes are parallel to the cross section area of the electric cable (250, 350) and intersect in the cross section area of the electric cable (250, 350), especially in the center of the cross section area, and especially wherein the axes are arranged orthogonal to each other.

3. Detection system (100) according to claim 1, wherein each sensor group (101, 102, 103, 201) comprises four shape sensors (104, 105, 204, 205, 304, 305, 310, 311), wherein in each case two of the shape sensors (104, 105, 204, 205, 304, 305, 310, 311) are positioned on a respective axis (360, 361) on opposing sides of the electric cable (250, 350), and wherein the two axes are parallel to the cross section area of the electric cable (250, 350) and intersect in the cross section area of the electric cable (250, 350), especially in the center of the cross section, and especially wherein the axes are arranged orthogonal to each other.

4. Detection system (100) according to any one of the preceding claims, wherein at least one of the shape sensors (104, 105, 204, 205, 304, 305, 310, 311) comprises a hall-effect sensor configured to sense a magnetic field that is created by the wires (251, 252, 253, 351, 352, 353, 355, 356, 357, 358) in the electric cable (250, 350) when the wires (251, 252, 253, 351, 352, 353, 355, 356, 357, 358) conduct electric current.

5. Detection system (100) according to any one of the preceding claims, comprising a detection processor (108) that is coupled to the shape sensors (104, 105, 204, 205, 304, 305, 310, 311) and that is configured to monitor the signals (106, 107) provided by the shape sensors (104, 105, 204, 205, 304, 305, 310, 311) for a change of the shape of the cross section area of the electric cable (250, 350) at the position of the respective sensor group (101, 102, 103, 201).

6. Detection system (100) according to claim 5, wherein the detection processor (108) is configured to store for each one of the shape sensors (104, 105, 204, 205, 304, 305, 310, 311) a target value and to determine if the signal (106, 107) provided by at least one of the shape sensors (104, 105, 204, 205, 304, 305, 310, 311) deviates from the respective target value by more than a predetermined threshold value, wherein the detection processor (108) is configured to output a positive deformation signal (109) if the signal (106, 107) provided by at least one of the shape sensors (104, 105, 204, 205, 304, 305, 310, 311) deviates from the respective target value by more than a predetermined threshold value.

7. Detection system (100) according to any one of the preceding claims 5 and 6, wherein the detection processor (108) is configured to output the positive deformation signal (109) if during operation of the detection system (100) the signal (106, 107) provided by at least one of the shape sensors (104, 105, 204, 205, 304, 305, 310, 311) changes more than a predetermined maximum change value.

8. Detection system (100) according to any one of the preceding claims 5 to 7, wherein the detection processor (108) is configured to output the positive deformation signal (109) if the signals (106, 107) provided by at least two shape sensors (104, 105, 204, 205, 304, 305, 310, 311) of the same sensor group (101, 102, 103, 201) that are positioned on different axes deviate from each other by more than a maximum deviation value.

9. Detection system (100) according to any one of the preceding claims 5 to 8, wherein the detection processor (108) is configured to output the positive deformation signal (109) only if the condition for outputting the positive deformation signal (109) exists for more than a predetermined amount of time.

10. Detection system (100) according to any one of the preceding claims, comprising a flexible sheet, wherein the shape sensors (104, 105, 204, 205, 304, 305, 310, 311) are embedded in the flexible sheet, and wherein the flexible sheet is configured to wrap around the electric cable (250, 350).

11. Electric cable (250, 350) comprising:
a number of electrical wires (251, 252, 253, 351, 352, 353, 355, 356, 357, 358);
a tubular insulation cover (254, 354), wherein the electrical wires (251, 252, 253, 351, 352, 353, 355, 356, 357, 358) are arranged in an inner open space surrounded by the tubular insulation cover (254, 354); and
a detection system (100) according to any one of the preceding claims 1 to 9, wherein the shape sensors (104, 105, 204, 205, 304, 305, 310, 311) are arranged in the material of the insulation cover.

12. Method for detecting deformations in an electric cable (250, 350), the method comprising:
sensing (S1) with a number of shape sensors (104, 105, 204, 205, 304, 305, 310, 311) arranged in a number of sensor groups (101, 102, 103, 201) that are provided consecutively on the electrical cable in a direction of longitudinal extension of the electrical cable a change of a shape of a cross section area of the electric cable (250, 350) at the position of the respective sensor group (101, 102, 103, 201); and
outputting (S2) with each one of the sensors a respective signal (106, 107).

13. Method according to claim 12, wherein sensing is performed with two shape sensors (104, 105, 204, 205, 304, 305, 310, 311) in each sensor group (101, 102, 103, 201), wherein each one of the two shape sensors (104, 105, 204, 205, 304, 305, 310, 311) is positioned on a respective axis (360, 361), and wherein the two axes are parallel to the cross section area of the electric cable (250, 350) and intersect in the cross section area of the electric cable (250, 350), especially in the center of the cross section area, and especially wherein the axes are arranged orthogonal to each other; or
wherein sensing is performed with four shape sensors (104, 105, 204, 205, 304, 305, 310, 311) in each sensor group (101, 102, 103, 201), wherein in each case two of the shape sensors (104, 105, 204, 205, 304, 305, 310, 311) are positioned on a respective axis (360, 361) on opposing sides of the electric cable (250, 350), and wherein the two axes are parallel to the cross section area of the electric cable (250, 350) and intersect in the cross section area of the electric cable (250, 350), especially in the center of the cross section area, and especially wherein the axes are arranged orthogonal to each other.

14. Method according to any one of the preceding method-based claims, wherein sensing is performed with at least one shape sensor (104, 105, 204, 205, 304, 305, 310, 311) comprising a hall-effect sensor configured to sense a magnetic field that is created by the wires (251, 252, 253, 351, 352, 353, 355, 356, 357, 358) in the electric cable (250, 350) when the wires (251, 252, 253, 351, 352, 353, 355, 356, 357, 358) conduct electric current.

15. Method according to any one of the preceding method-based claims, comprising outputting a positive deformation signal (109) if the signal (106, 107) provided by at least one of the shape sensors (104, 105, 204, 205, 304, 305, 310, 311) deviates from a respective target value by more than a predetermined threshold value; and/or
comprising outputting a positive deformation signal (109) if the signal (106, 107) provided by at least one of the shape sensors (104, 105, 204, 205, 304, 305, 310, 311) changes more than a predetermined maximum change value while the method is performed; and/or
comprising outputting a positive deformation signal (109) if the signals (106, 107) provided by at least two shape sensors (104, 105, 204, 205, 304, 305, 310, 311) of the same sensor group (101, 102, 103, 201) that are positioned on different axes deviate from each other by more than a maximum deviation value; and/or
wherein the positive deformation signal (109) is output only if the condition for outputting the positive deformation signal (109) exists for more than a predetermined amount of time.
